# FASCICULE DE BREVET EUROPEEN

(11) **EP 0 991 194 B1**
(45) Date de publication et mention de la délivrance du brevet: **03.12.2003**
(21) Numéro de dépôt: 99402372.9
(22) Date de dépôt: 29.09.1999
(51) Int. Cl.: H03L 7/099, H03L 7/085

(54) **Procédé et dispositif de génération d'un signal d'horloge**
Verfahren und Schaltungsanordnung zur Erzeugung eines Taktsignals
Process and circuit arrangement for generating a clock signal

(30) Priorité: 30.09.1998 FR 9812250
(43) Date de publication de la demande: 05.04.2000
(73) Titulaire: STMicroelectronics S.A., 92120 Montrouge (FR)
(72) Inventeur: Stroeble, Olaf, 38700 La Tronche (FR)
(74) Mandataire: Casalonga, Axel

(56) Documents cités:
- EP-A- 0 644 657
- WO-A-81/01928
- DE-A- 2 815 984
- US-A- 5 790 614
- URBANSKY R ET AL: "DESIGN ASPECTS AND ANALYSIS OF SDH EQUIPMENT CLOCKS" EUROPEAN TRANSACTIONS ON TELECOMMUNICATIONS AND RELATED TECHNOLOGIES., vol. 7, no. 1, 1 janvier 1996 (1996-01-01), pages 39-48, XP000580347 MILANO IT
- PERROTT M H ET AL: "A 27-MW CMOS FRACTIONAL-N SYNTHESIZER USING DIGITAL COMPENSATION FOR 2.5-MB/S GFSK MODULATION" IEEE JOURNAL OF SOLID-STATE CIRCUITS., vol. 32, no. 12, 1 décembre 1997 (1997-12-01), pages 2048-2060, XP000767454 NEW YORK US

## Description

L'invention concerne la génération d'un signal d'horloge et plus particulièrement la génération d'un signal d'horloge pour un système de réception d'un flot de données numériques cadencé par un signal d'horloge maître dont la fréquence est fixée.

L'invention s'applique avantageusement mais non limitativement à la réception d'informations numériques transmises par liaison satellite.

Dans les systèmes de transmission de données numériques en général, le signal d'horloge pour la récupération des données au sein du récepteur doit être verrouillé sur le signal d'horloge utilisé pour l'émission. Généralement, l'émetteur utilise un signal d'horloge très stable. Pour générer au sein du récepteur le signal d'horloge de récupération, également dénommé dans la suite du texte "signal d'horloge principal", on utilise des systèmes classiques de récupération d'horloge. Ceci étant, le signal d'horloge principal peut disparaître temporairement pour des causes diverses. Dans ce cas, il est prévu d'utiliser un quartz générant un signal d'horloge secondaire dont la valeur nominale de la fréquence est égale à celle de la fréquence du signal d'horloge principal (et donc du signal d'horloge de l'émetteur). Cependant, la fréquence du signal d'horloge principal et celle du signal d'horloge secondaire peuvent différer de quelques dizaines de ppm (parties par millions) selon la précision du quartz utilisé. Il peut en résulter alors, lors de la détection de la perte du signal d'horloge principal et de la commutation sur le signal d'horloge secondaire, des pertes de données numériques, en raison des différences de fréquence et de phase entre le signal d'horloge secondaire et le signal d'horloge principal qui vient d'être perdu.

Afin de remédier à ces inconvénients, une solution consiste à utiliser une boucle analogique à verrouillage de phase classique, dont l'une des entrées du comparateur de phase reçoit soit le signal d'horloge principal (s'il est présent), soit le signal d'horloge secondaire (généré par le quartz) en cas de perte du signal principal. Cependant, si lors de la commutation du signal à l'entrée du comparateur de phase, la différence de phase entre le signal principal qui vient d'être perdu et le signal émis par le quartz, est relativement importante, il se produit alors des variations de phase et de fréquence importantes, en raison notamment de la variation de courant injecté dans le filtre de la boucle à verrouillage de phase. L'écart entre la fréquence du signal de sortie de la boucle à verrouillage de phase et la fréquence du signal d'horloge principal peut alors être temporairement relativement élevé, conduisant par exemple à l'obtention d'un signal d'horloge de sortie ayant une fréquence relativement plus élevée que celle du signal d'horloge principal. Dans ces conditions, les mémoires tampon qui sont habituellement utilisées pour stocker les données reçues peuvent être plus rapidement remplies que prévu, occasionnant donc des pertes de données à la réception.

Il a alors été envisagé de diminuer la valeur de la résistance du filtre de la boucle à verrouillage de phase, de façon à diminuer notamment les sauts de fréquences pendant ce régime transitoire. Cependant, ceci conduit à des constantes de temps plus importantes et par conséquent à des durées de verrouillage ainsi qu'à des gigues ("jitter" en langue anglaise) plus élevées. Or, ces valeurs plus élevées s'avèrent incompatibles avec certaines applications.

L'invention vise à apporter une solution plus satisfaisante à ces problèmes.

L'invention vise à générer un signal d'horloge de sortie dont l'écart de fréquence par rapport à la fréquence du signal d'horloge principal reste en permanence inférieur à un seuil prédéterminé qui peut être choisi très faible, par exemple 100 ppm en valeur absolue, même en cas de perte temporaire du signal d'horloge principal.

En d'autres termes, l'invention permet, en cas de perte du signal d'horloge principal, de supprimer les sauts importants de phase et de fréquence préjudiciables à la réception correcte des données numériques.

Pour atteindre ces buts, l'invention propose une solution radicalement différente de celle prévoyant l'utilisation d'une boucle à verrouillage de phase analogique classique.

L'invention propose donc un procédé de génération d'un signal d'horloge, dit "de sortie", à partir d'un signal d'horloge principal ayant une fréquence principale prédéterminée, et d'un signal d'horloge secondaire (généré par exemple par un quartz). On commande alors par un signal logique de commande à deux états, un synthétiseur de fréquence qui reçoit le signal d'horloge secondaire. Le synthétiseur élabore et délivre alors sélectivement, en tant que signal d'horloge de sortie, un premier ou un deuxième signal d'horloge auxiliaire, selon que le signal de commande est respectivement dans son premier ou dans son deuxième état. Le premier signal auxiliaire a une première fréquence auxiliaire égale à la valeur de la fréquence principale augmentée d'un écart fréquentiel prédéterminé (par exemple +50 ppm environ) supérieur à la précision fréquentielle du signal d'horloge secondaire (c'est-à-dire le quartz). Le deuxième signal auxiliaire a une deuxième fréquence auxiliaire égale à la valeur de la fréquence secondaire diminuée de l'écart fréquentiel prédéterminé (par exemple -50 ppm environ). On détermine alors l'un ou l'autre des deux états du signal logique en fonction de la différence de phase entre d'une part le signal d'horloge auxiliaire délivré par le synthétiseur de fréquence (c'est-à-dire en fait le signal d'horloge délivré en sortie du synthétiseur de fréquence) et d'autre part le signal d'horloge principal qui peut être éventuellement altéré. On génère ainsi en sortie du synthétiseur de fréquence, le signal d'horloge de sortie, dont l'écart de fréquence par rapport à ladite fréquence principale reste en permanence inférieur à un seuil prédéterminé (par exemple ± 100 ppm), ce seuil prédéterminé dépendant dudit écart fréquentiel et de la précision fréquentielle du générateur du signal secondaire (c'est-à-dire la précision fréquentielle du quartz), et ce même en cas de perte du signal principal.

En d'autres termes, le signal d'horloge de sortie qui est ainsi généré, est en permanence l'un ou l'autre des deux signaux d'horloge auxiliaires préprogrammés dans le synthétiseur de fréquence et dont la sélection dépend de la différence de phase entre le signal de sortie du synthétiseur et le signal d'horloge principal.

En pratique, le seuil prédéterminé (± 100 ppm environ) pour l'écart de fréquence du signal d'horloge de sortie par rapport à la fréquence du signal d'horloge principal, est égal à la somme de l'écart fréquentiel préprogrammé dans le synthétiseur (en l'espèce 50 ppm environ), et de la précision du quartz (en l'espèce de l'ordre de 50 ppm).

Selon un mode de mise en oeuvre du procédé, on confère au signal logique de commande son premier état lorsque le signal auxiliaire délivré par le synthétiseur (c'est-à-dire en fait le signal d'horloge de sortie) présente un retard de phase par rapport au signal principal. En d'autres termes, dans ce cas, on force le synthétiseur à délivrer en sortie le premier signal auxiliaire dont la fréquence est légèrement supérieure à celle du signal principal. En outre, on confère au signal logique son deuxième état lorsque le signal auxiliaire délivré par le synthétiseur est en avance de phase par rapport au signal principal. En d'autres termes, dans ce cas, on force le synthétiseur à délivrer en sortie le deuxième signal auxiliaire, c'est-à-dire celui ayant une fréquence légèrement inférieure à celle du signal principal.

L'invention a également pour objet un dispositif électronique de génération d'un signal d'horloge de sortie. Selon une caractéristique générale de l'invention, ce dispositif comprend une entrée principale pour recevoir un signal d'horloge principal ayant une fréquence principale prédéterminée, ainsi qu'un générateur d'un signal d'horloge secondaire. Le dispositif comprend également un synthétiseur de fréquence recevant le signal d'horloge secondaire ainsi qu'un signal logique de commande à deux états. Le synthétiseur de fréquence élabore et délivre, en tant que signal d'horloge de sortie, sélectivement l'un ou l'autre de premier et deuxième signaux d'horloge auxiliaires selon que le signal de commande est respectivement dans ses premier et deuxième états. Le premier signal auxiliaire a une première fréquence auxiliaire égale à la valeur de la fréquence principale augmentée d'un écart fréquentiel prédéterminé supérieur à la précision fréquentielle du signal d'horloge secondaire, tandis que le deuxième signal auxiliaire a une deuxième fréquence auxiliaire égale à la valeur de la fréquence principale diminuée dudit écart fréquentiel prédéterminé. Le dispositif comporte par ailleurs des moyens de commande ayant une première entrée de commande reliée à ladite entrée principale (c'est-à-dire recevant le signal d'horloge principal éventuellement altéré) et une deuxième entrée de commande reliée à la sortie du synthétiseur de fréquence (c'est-à-dire recevant l'un ou l'autre des deux signaux auxiliaires, donc en fait le signal d'horloge de sortie). Ces moyens de commande sont aptes à délivrer ledit signal logique de commande et à lui conférer l'un ou l'autre de ces deux états en fonction de la différence de phase entre les signaux respectivement présents aux deux entrées de commande.

Selon un mode de réalisation de l'invention, les moyens de commande confèrent au signal logique son premier état lorsque le signal présent à la deuxième entrée de commande (c'est-à-dire le signal de sortie du synthétiseur) présente un retard de phase par rapport au signal présent à la première entrée de commande, tandis qu'ils confèrent au signal logique son deuxième état lorsque le signal présent à la deuxième entrée de commande est en avance de phase par rapport au signal présent à la première entrée de commande.

Les moyens de commande comportent avantageusement un détecteur de phase et de fréquence dont les deux entrées sont reliées aux deux entrées de commande et délivrant sur ses deux sorties deux impulsions dont les durées respectives dépendent de la différence de de phase entre les signaux présents aux deux entrées. Il est également prévu deux filtres passe-bas qui sont respectivement connectés aux deux sorties du détecteur de phase et de fréquence (ces deux filtres passe-bas réalisant en fait une moyenne des impulsions délivrées par le détecteur de fréquence et de phase). Enfin, les moyens de commande comportent des moyens de comparaison dont les deux entrées sont reliées aux deux sorties des deux filtres et dont la sortie délivre le signal logique de commande.

Afin de garantir que le niveau du signal délivré par chaque filtre n'est pas inférieur à la tension de décalage (offset) du comparateur, les moyens de comparaison comportent avantageusement deux moyens de décalage de niveau, précédant le comparateur, et aptes à augmenter le niveau de chaque signal délivré par chaque filtre d'une même valeur prédéterminée.

D'autres avantages et caractéristiques de l'invention apparaîtront à l'examen de la description détaillée de modes de mise en oeuvre et de réalisation, nullement limitatifs, et des dessins annexés, sur lesquels :
- la figure 1 illustre très schématiquement l'architecture d'un dispositif de génération de signal d'horloge selon l'invention;
- la figure 2 illustre très schématiquement un signal d'horloge principal et les deux signaux d'horloge auxiliaires préprogrammés dans le synthétiseur de fréquence;
- les figures 3 et 4 illustrent respectivement deux configurations correspondant respectivement aux deux états logiques du signal de commande; et
- la figure 5 illustre des variations temporelles de fréquence et de phase du signal d'horloge générées par le procédé et le dispositif selon l'invention.

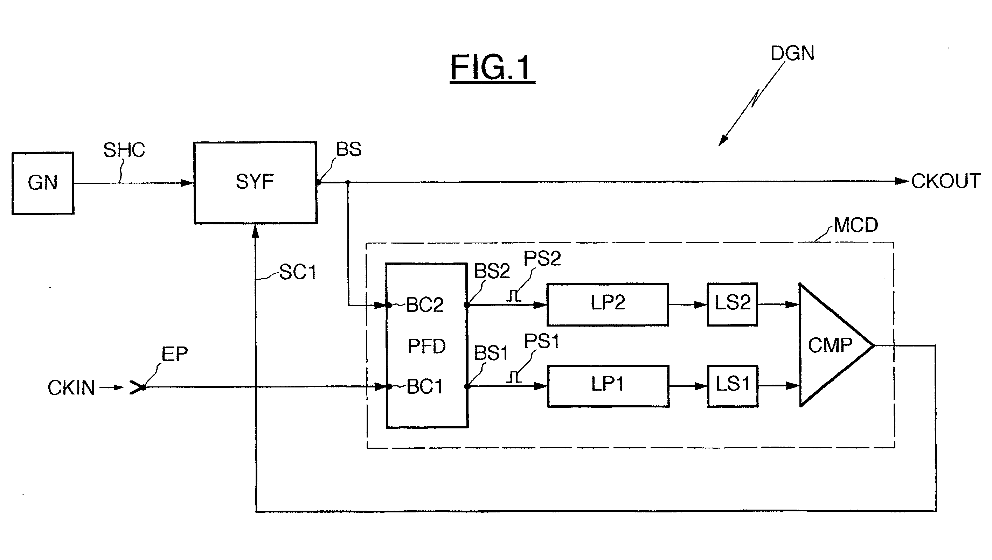

Sur la figure 1, la référence EP désigne une entrée principale destinée à recevoir un signal d'horloge principal CKIN ayant une fréquence principale prédéterminée et fixe. Dans la suite du texte, on désignera par F0 la fréquence principale et par T0 la période correspondante. A titre d'exemple, la fréquence F0 peut être égale à 16,384 MHz.

La borne de sortie BS du dispositif DGN selon l'invention délivre un signal d'horloge de sortie CKOUT à partir, comme on va le voir plus en détail ci-après, du signal d'horloge principal CKIN et d'un signal d'horloge dit "secondaire" SHC délivré par exemple par un quartz dont la fréquence FQ peut avoir une valeur nominale FQ0 égale à la fréquence F0 du signal d'horloge principal. Ceci étant, la fréquence nominale FQ0 du quartz peut être choisie différente de la fréquence F0.

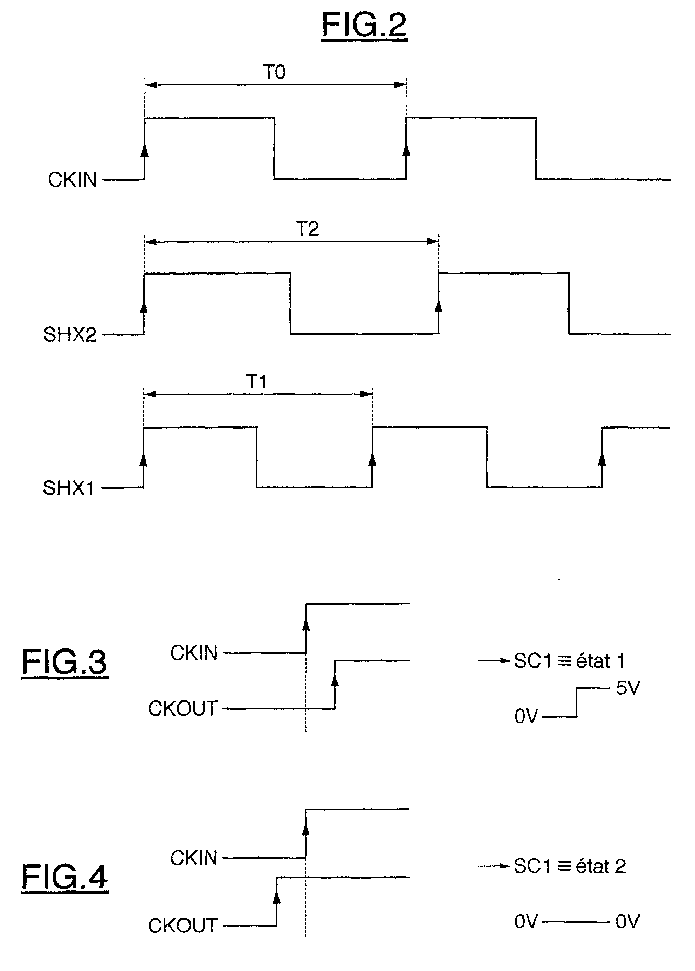

Quoi qu'il en soit, le signal SHC délivré par le quartz GN sert de référence à un synthétiseur de fréquence SYF. Ce synthétiseur de fréquence est préprogrammé de façon à délivrer exclusivement et sélectivement, à partir du signal délivré par le quartz, deux signaux d'horloge auxiliaires SHX1, SHX2 (figure 2). Le premier signal d'horloge auxiliaire SHX1 a une fréquence F1 choisie légèrement supérieure à la fréquence F0, tandis que la fréquence F2 du deuxième signal d'horloge auxiliaire SHX2 est choisie légèrement inférieure à la fréquence F0. En pratique, la fréquence F1 est égale à la fréquence F0 augmentée d'un écart fréquentiel prédéfini ΔF, par exemple 50 ppm (F1=16,3848 MHz), tandis que la fréquence F2 est égale à la fréquence F0 diminuée de ce même écart fréquentiel ΔF (F2=16,3832 MHz).

En outre, la fréquence FQ du quartz peut varier autour de sa valeur nominale dans une plage fréquentielle prédéfinie qui dépend de la précision ΔFQ du quartz. En d'autres termes, la fréquence du quartz peut varier entre (FQ0-ΔFQ) et (FQ0+ΔFQ).

Il en résulte donc également une précision de ± ΔFQ sur les fréquences F1 et F2 des signaux auxiliaires SHX1 et SHX2.

Afin d'éviter un risque d'instabilité de la boucle d'asservissement composée du synthétiseur et des moyens de commande qui vont être décrits ci-après, il convient de choisir un écart fréquentiel ΔF supérieur, même très légèrement (par exemple 1 ou 2 ppm) à la précision ΔFQ du quartz.

Tout synthétiseur de fréquence peut être utilisé dans le dispositif DGN selon l'invention, notamment un synthétiseur de fréquence à division fractionnaire, comme par exemple celui décrit dans l'article de Michael H. Perrott, intitulé "27-mW CMOS Fractional-N Synthetiseur Using Digital Compensation for 2.5-Mb/s GFSK Modulation" (IEEE Journal of Solid-State Circuits, Vol. 32, n°12, Décembre 1997).

L'une des caractéristiques intrinsèques d'un synthétiseur de fréquence, notamment un synthétiseur de fréquence à division fractionnaire, est de ne délivrer qu'un seul signal de sortie dont la fréquence peut être différente en fonction de la préprogrammation du synthétiseur. Et lorsque la fréquence du signal de sortie délivré par le synthétiseur est modifiée pour prendre l'une ou l'autre des deux valeurs préprogrammées, il n'y a pas de saut de phase entre le signal de sortie précédant la modification et le signal de sortie suivant la modification. Ceci est particulièrement important dans la présente invention qui vise à supprimer tout saut important de phase.

Le synthétiseur de fréquence utilisé dans le dispositif selon l'invention est commandé par un signal logique de commande SC1 possédant deux états. En pratique, ce signal logique de commande qui correspond en fait à un bit de commande, est un signal qui peut prendre deux niveaux de tension correspondant aux deux états et donc aux deux valeurs correspondantes du bit de commande. Par exemple, le premier état du signal SC1 correspond à un niveau +5 Volts, tandis que le deuxième état du signal SC1 correspond à un niveau 0 Volt.

Ce signal de commande SC1 est délivré en sortie des moyens de commande MCD dont on va maintenant décrire plus en détail la structure.

Ces moyens de commande MCD comportent en tête un détecteur de phase et de fréquence PFD, de structure classique qui est parfaitement connu de l'homme du métier. A titre indicatif, le circuit PFD est réalisé à base de portes logiques. Le détecteur PFD délivre sur ses deux sorties BS 1 et BS2 des impulsions PS1 et PS2 dont les durées respectives dépendent de la différence de phase des signaux présents aux deux entrées BC1 et BC2 du détecteur PFD. En pratique, avec les technologies actuelles de réalisation, deux signaux en phase à l'entrée du détecteur PFD donneront lieu à l'émission de deux impulsions PS1 et PS2 de durée identique. De même, deux signaux fortement déphasés présents à l'entrée du détecteur PFD donneront également lieu à l'émission de deux impulsions PS1 et PS2. Cependant, l'une de ces impulsions sera de durée extrêmement réduite, tandis que l'autre sera de durée plus importante. Et, selon le signe de la phase, ce sera l'une ou l'autre des impulsions PS1 et PS2 qui présentera la durée la plus longue.

Les impulsions respectives PS1 et PS2 sont ensuite délivrées respectivement dans deux filtres passe-bas LP1 et LP2 dont la fonction est de réaliser une moyenne du niveau des différentes impulsions reçues en entrée des filtres. A titre indicatif, la constante de temps de chaque filtre peut être choisie de l'ordre de 1 µs dans l'exemple décrit.

Chaque niveau moyenné délivré par un filtre est ensuite élevé en amplitude dans un moyen de décalage de niveau (LS1, LS2) de structure classique. Cette élévation de niveau a pour but de garantir que les deux valeurs qui seront comparées dans le comparateur CMP se situeront au-dessus de la tension d'offset du comparateur de façon à garantir une comparaison correcte. Selon le résultat de la comparaison, le signal de commande SC1 prendra, soit son premier état, soit son deuxième état.

L'homme du métier remarque donc tout d'abord que le signal CKOUT est en fait, soit le signal SHX1, soit le signal SHX2. Chacun de ces deux signaux auxiliaires présente une différence de fréquence par rapport au signal d'horloge principal CKIN, compte tenu notamment du fait que l'écart fréquentiel ΔF est supérieur à la précision ΔQF du quartz.

Dans le cas illustré sur la figure 3, le signal CKOUT est en retard de phase par rapport au signal CKIN. Aussi, lorsque ces deux signaux CKIN et CKOUT sont respectivement reçus aux deux entrées du détecteur PFD, celui-ci va délivrer respectivement sur ses deux sorties une impulsion PS2 (par exemple) de durée plus longue que l'impulsion PS1, ce qui après comparaison va conduire à conférer au signal de commande SC1 son premier état, forçant alors le synthétiseur SYF à délivrer sur sa borne de sortie le signal auxiliaire SHX1 qui a une fréquence légèrement supérieure à celle du signal CKIN.

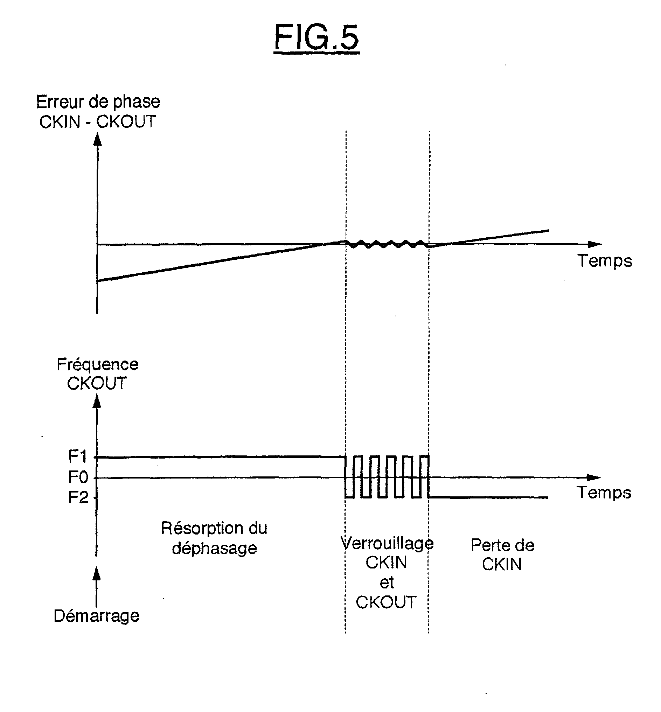

De même, dans le cas illustré sur la figure 4 qui correspond à la présentation aux entrées du détecteur PFD du signal CKIN et du signal CKOUT en avance de phase par rapport au signal CKIN, le niveau moyen des impulsions PS1 sera cette fois-ci supérieur au niveau moyen des impulsions PS2, conduisant alors le comparateur CMP à conférer au signal de commande SC1 son deuxième état, en réponse auquel le synthétiseur de fréquence va délivrer sur sa borne de sortie le signal SHX2 dont la fréquence est légèrement inférieure à celle du signal CKIN.

On va maintenant décrire en se référant plus particulièrement à la figure 5, un cas concrêt de fonctionnement au cours duquel va se produire une perte temporaire du signal CKIN.

On suppose tout d'abord qu'au démarrage du dispositif, le signal CKIN est présent et que l'erreur de phase CKIN-CKOUT est de l'ordre de -90°. On se trouve donc dans la configuration de la figure 3, le signal CKOUT présentant un retard de phase par rapport au signal CKIN. Dans ces conditions, le niveau moyenné des impulsions PS2 va être supérieur au niveau moyenné des impulsions PS1, conduisant le signal SC1 dans son premier état. Par conséquent, le synthétiseur de fréquence SYF va délivrer sur sa borne de sortie le premier signal d'horloge auxiliaire SHX1 ayant la fréquence F1 légèrement supérieure à la fréquence F0. L'erreur de phase va progressivement se résorber de façon linéaire. Durant cette phase de résorption, le synthétiseur de fréquence SYF délivre toujours le signal auxiliaire SHX1 à la fréquence F1. Lorsque l'erreur de phase s'est résorbée, c'est-à-dire lorsque l'on se retrouve dans la configuration de la figure 4 avec le signal auxiliaire SHX1 délivré par le synthétiseur de fréquence SYF, en avance de phase par rapport au signal CKIN, c'est cette fois-ci le niveau moyenné des impulsions PS1 qui va être supérieur au niveau moyenné des impulsions PS2, faisant passer le signal SC 1 dans son deuxième état. En conséquence, le synthétiseur de fréquence SYF commute alors sur le signal SHX2 de fréquence F2. On rentre alors dans une phase de verrouillage entre le signal d'horloge CKOUT et le signal d'horloge CKIN. Au cours de cette phase de verrouillage, et puisque les signaux auxiliaires SHX1 et SHX2 n'ont pas exactement la même fréquence que le signal CKIN, le synthétiseur SYF va successivement et: alternativement délivrer les signaux SHX2 et SHX1. Il convient de noter ici que la durée de délivrance d'un signal auxiliaire est sensiblement égale à la constante de temps des filtres LP1 et LP2.

En cas de perte du signal CKIN, correspondant à une absence de transition de ce signal, les moyens de commande MCD vont alors considérer que le signal auxiliaire délivré par le synthétiseur de fréquence est en avance de phase par rapport au signal présent sur la borne BC1 du détecteur PFD et vont par conséquent placer le signal de commande SC1 dans son deuxième état, ce qui correspond à la délivrance du signal SHX2 de fréquence F2. Le synthétiseur va alors délivrer constamment le signal SHX2 tant que le signal CKIN ne réapparaît pas.

A la réapparition du signal CKIN, le processus qui vient d'être décrit dans la phase de résorption de l'erreur de phase va se reproduire de façon à réduire linéairement l'erreur de phase entre le signal CKIN qui est réapparu et le signal de sortie CKOUT.

L'homme du métier remarque donc que, dans la phase de verrouillage des signaux d'horloge CKIN et CKOUT, il existe une très petite gigue structurelle due aux commutations successives du synthétiseur de fréquence. Cette gigue est de l'ordre de 6 picosecondes pic à pic avec un écart fréquentiel ΔF de 50 ppm en valeur absolue, ce qui est absolument négligeable. Par ailleurs, cet écart fréquentiel entre la fréquence du signal de sortie CKOUT et la fréquence F0 du signal CKIN reste limité à ±50 ppm, quelle que soit la situation du signal CKIN. Si l'on considère par ailleurs que la précision ΔFQ du quartz est de l'ordre de ±50 ppm, il en résulte que le dispositif selon l'invention permet de générer un signal d'horloge CKOUT dont l'écart de fréquence par rapport à la fréquence F0 du signal CKIN reste en permanence inférieur à un seuil prédéterminé, en l'espèce ±100 ppm environ.

Enfin, le système selon l'invention présente l'avantage considérable de permettre une résorption linéaire de l'erreur de phase, ce qui permet de résorber cette erreur de phase beaucoup plus rapidement que dans le cas d'une boucle à verrouillage de phase analogique classique.

## Revendications

1. Procédé de génération d'un signal d'horloge de sortie, à partir d'un signal d'horloge principal (CKIN) ayant une fréquence principale prédéterminée (F0), et d'un signal d'horloge secondaire (SHC), dans lequel on commande par un signal logique de commande (SC1) à deux états, un synthétiseur de fréquences (SYF) recevant le signal d'horloge secondaire, le synthétiseur élaborant et délivrant sélectivement, en tant que signal d'horloge de sortie, l'un ou l'autre de premier et deuxième signaux d'horloge auxiliaires (SHX1, SHX2) selon que le signal de commande est respectivement dans ses premier et deuxième états, le premier signal auxiliaire (SHX1) ayant une première fréquence auxiliaire (F1) égale à la valeur de la fréquence secondaire augmentée d'un écart fréquentiel prédéterminé supérieur à la précision fréquentielle (ΔFQ) du signal d'horloge secondaire, et le deuxième signal auxiliaire (SHX2) ayant une deuxième fréquence auxiliaire (F2) égale à la valeur de la fréquence secondaire diminuée dudit écart fréquentiel prédéterminé, et on détermine l'un ou l'autre des deux états du signal logique (SC1) en fonction de la différence de phase entre d'une part le signal d'horloge auxiliaire (CKOUT) délivré par le synthétiseur de fréquences et d'autre part le signal d'horloge principal (CKIN) éventuellement altéré, de façon à générer en sortie du synthétiseur de fréquences, un signal d'horloge de sortie (CKOUT) dont l'écart de fréquence par rapport à ladite fréquence principale reste en permanence inférieur à un seuil prédéterminé dépendant dudit écart fréquentiel et de la précision fréquentielle du générateur du signal secondaire, même en cas de perte temporaire du signal principal.

2. Procédé selon la revendication 1, **caractérisé par le fait qu'**on confère au signal logique (SC1) son premier état lorsque le signal auxiliaire délivré par le synthétiseur présente un retard de phase par rapport au signal principal (CKIN), et **par le fait qu'**on confère au signal logique son deuxième état lorsque le signal auxiliaire délivré par le synthétiseur est en avance de phase par rapport au signal principal.

3. Dispositif électronique de génération d'un signal d'horloge de sortie, **caractérisé par le fait qu'**il comprend une entrée principale (EP) pour recevoir un signal d'horloge principal (CKIN) ayant une fréquence principale prédéterminée, un générateur (GN) d'un signal d'horloge secondaire (SHC), un synthétiseur de fréquence (SYF) recevant le signal d'horloge secondaire ainsi qu'un signal logique de commande à deux états (SC1) et élaborant et délivrant, en tant que signal d'horloge de sortie (CKOUT), sélectivement l'un ou l'autre de premier et deuxième signaux d'horloge auxiliaires (SHX1, SHX2) selon que le signal de commande (SC1) est respectivement dans ses premier et deuxième états, le premier signal auxiliaire (SHX1) ayant une première fréquence auxiliaire égale à la valeur de la fréquence secondaire augmentée d'un écart fréquentiel prédéterminé supérieur à la précision fréquentielle (ΔFQ) du signal d'horloge secondaire, et le deuxième signal auxiliaire (SHX2) ayant une deuxième fréquence auxiliaire égale à la valeur de la fréquence secondaire diminuée dudit écart fréquentiel prédéterminé, et des moyens de commande (MCD) ayant une première entrée de commande (BC1) reliée à ladite entrée principale (EP), une deuxième entrée de commande (BC2) reliée à la sortie du synthétiseur de fréquence, et aptes à délivrer ledit signal logique et à lui conférer l'un ou l'autre de ses deux états en fonction de la différence de phase entre les signaux respectivement présents aux deux entrées de commande, de façon à générer en sortie du synthétiseur de fréquence, un signal d'horloge de sortie (CKOUT) dont l'écart de fréquence par rapport à ladite fréquence principale reste en permanence inférieur à un seuil prédéterminé dépendant dudit écart fréquentiel et de la précision fréquentielle du générateur du signal secondaire, même en cas de perte temporaire du signal principal.

4. Dispositif selon la revendication 3, **caractérisé par le fait que** les moyens de commande (MCD) confèrent au signal logique son premier état lorsque le signal auxiliaire délivré par le synthétiseur présente un retard de phase par rapport au signal (CKIN) présent à la première entrée de commande, et **par le fait que** les moyens de commande confèrent au signal logique son deuxième état lorsque le signal auxiliaire délivré par le synthétiseur est en avance de phase par rapport au signal présent à la première entrée de commande.

5. Dispositif selon la revendication 3 ou 4, **caractérisé par le fait que** les moyens de commande comportent un détecteur de phase et de fréquence (PFD) dont les deux entrées sont reliées aux deux entrées de commande et délivrant sur ses deux sorties (BS1, BS2) deux impulsions (PS1, PS2) dont les durées respectives dépendent de la différence de phase entre les signaux présents aux deux entrées (BC1, BC2), deux filtres passe-bas (LP1, LP2) respectivement connectés aux deux sorties du détecteur de phase et de fréquence, et des moyens de comparaison (CMP) dont les deux entrées sont reliées aux deux sorties des deux filtres, et dont la sortie délivre ledit signal logique (SC1).

6. Dispositif selon la revendication 5, **caractérisé par le fait que** les moyens de'comparaison comportent un comparateur (CMP) précédé de deux moyens de décalage de niveau (LS 1, LS2) aptes à augmenter le niveau de chaque signal délivré par chaque filtre d'une même valeur prédéterminée.

## Patentansprüche

1. Verfahren zur Erzeugung eines Taktausgangssignals, ausgehend von einem Haupttaktsignal (CKIN) mit einer vorgegebenen Hauptfrequenz (F0) und einem sekundären Taktsignal (SHC),
wobei ein das sekundäre Taktsignal empfangender Frequenzaufbereiter (SYF) durch ein Zwei-Zustand-Steuerlogiksignal (SC1) gesteuert wird, wobei der Aufbereiter das eine oder das andere des ersten und zweiten Hilfstaktsignals (SHX1, SHX2) verarbeitet und selektiv als Taktausgangssignal ausgibt, je nachdem, ob das Steuersignal in seinem ersten bzw. seinem zweiten Zustand ist, wobei das erste Hilfssignal (SHX1) eine erste Hilfsfrequenz (F1) hat, die gleich dem Wert der sekundären Frequenz erhöht um einen vorgegebenen Frequenzabstand ist, der größer als die Frequenzgenauigkeit (ΔFQ) des sekundären Taktsignals ist, und das zweite Hilfssignal (SHX2) eine zweite Hilfsfrequenz (F2) hat, die gleich dem Wert der sekundären Frequenz vermindert, um den vorgegebenen Frequenzabstand ist, und
wobei der eine oder der andere der zwei Zustände des Logiksignals (SC1) als Funktion der Phasendifferenz zwischen einerseits dem vom Frequenzaufbereiter ausgegebenen Hilfstaktsignal (CKOUT) und andererseits dem eventuell geänderten Haupttaktsignal (CKIN) festgelegt wird, um so, selbst im Falle des temporären Verlusts des Hauptsignals, am Ausgang des Frequenzaufbereiters ein Taktausgangssignal (CKOUT) zu erzeugen, dessen Frequenzabweichung bezüglich der Hauptfrequenz ständig unterhalb einer vorgegebenen Schwelle bleibt, die von dem Frequenzabstand und der Frequenzgenauigkeit des Generators des zweiten Signals abhängt.

2. Verfahren nach Anspruch 1, **dadurch gekennzeichnet, daß** das Logiksignal (SC1) in seinen ersten Zustand gesetzt wird, wenn das vom Aufbereiter ausgegebene Hilfssignal dem Hauptsignal (CKIN) in der Phase nacheilt, und dadurch, daß das Logiksignal in seinen zweiten Zustand gesetzt wird, wenn das vom Aufbereiter ausgegebene Hilfssignal dem Hauptsignal in der Phase vorauseilt.

3. Elektronische Vorrichtung zur Erzeugung eines Taktausgangssignals, **dadurch gekennzeichnet, daß** sie aufweist:
einen Haupteingang (EP) zum Empfangen eines Haupttaktsignals (CKIN) einer vorgegebenen Hauptfrequenz,
einen Generator (GN) eines sekundären Taktsignals (SHC),
einen Frequenzaufbereiter (SYF), der das sekundäre Taktsignal sowie ein Zwei-Zustand-Steuerlogiksignal (SC1) empfängt und das eine oder das andere des ersten und zweiten Hilfstaktsignals (SHX1,SHX2) verarbeitet und als Taktausgangssignal (CKOUT) selektiv ausgibt, je nachdem, ob das Steuersignal (SC1) in seinem ersten bzw. seinem zweiten Zustand ist, wobei das erste Hilfssignal (SHX1) eine erste Hilfsfrequenz hat, die gleich dem Wert der sekundären Frequenz erhöht um einen vorgegebenen Frequenzabstand ist, der größer als die Frequenzgenauigkeit (ΔFQ) des sekundären Taktsignals ist, und das zweite Hilfstaktsignal (SHX2) eine zweite Hilfsfrequenz hat, die gleich dem Wert der sekundären Frequenz vermindert um den vorgegebenen Frequenzabstand ist, und
Steuerungseinrichtungen (MCD), die einen mit dem Haupteingang (EP) verbundenen ersten Steuereingang (BC1), einen mit dem Ausgang des Frequenzaufbereiters verbundenen zweiten Steuereingang (BC2) haben und in der Lage sind, das Logiksignal auszugeben und es abhängig von der Phasendifferenz zwischen den an den zwei Steuereingängen anliegenden Signalen in den einen oder den anderen seiner zwei Zustände zu setzen, um so, selbst im Falle des temporären Verlusts des Hauptsignals, am Ausgang des Frequenzaufbereiters ein Taktausgangssignal (CKOUT) zu erzeugen, dessen Frequenzabweichung bezüglich der Hauptfrequenz ständig unterhalb einer vorgegebenen Schwelle bleibt, die von dem Frequenzabstand und der Frequenzgenauigkeit des Generators des sekundären Signals abhängig ist.

4. Vorrichtung nach Anspruch 3, **dadurch gekennzeichnet, daß** die Steuereinrichtungen (MCD) das Logiksignal in seinen ersten Zustand setzen, wenn das von dem Aufbereiter ausgegebene Hilfssignal dem am ersten Steuereingang anliegenden Signal (CKIN) in der Phase nacheilt, und dadurch, daß die Steuereinrichtungen das Logiksignal in seinen zweiten Zustand setzen, wenn das von dem Aufbereiter ausgegebene Hilfssignal dem am ersten Steuereingang anliegenden Signal in der Phase vorauseilt.

5. Vorrichtung nach Anspruch 3 oder 4, **dadurch gekennzeichnet, daß** die Steuereinrichtungen aufweisen:
eine Phasen- und Frequenzerfassungsvorrichtung (PFD), deren zwei Eingänge mit den zwei Steuereingängen verbunden sind und die an ihren zwei Ausgängen (BS1,BS2) zwei Impulse (PS1,PS2) ausgibt, deren jeweilige Dauer von der Phasendifferenz zwischen den an den zwei Eingängen (BC1,BC2) anliegenden Signalen abhängt,
zwei Tiefpaßfilter (LP1,LP2), die jeweils mit den zwei Ausgängen der Phasen- und Frequenzerfassungsvorrichtung verbunden sind, und
Vergleichseinrichtungen (CMP), deren zwei Eingänge mit den zwei Ausgängen der zwei Filter verbunden sind und deren Ausgang das Logiksignal (SC1) ausgibt.

6. Vorrichtung nach Anspruch 5, **dadurch gekennzeichnet, daß** die Vergleichseinrichtungen einen Komparator (CMP) aufweisen, dem zwei Pegelverschiebungseinrichtungen (LS1,LS2) vorausgehen, die den Pegel jedes von jedem Filter ausgegebenen Signals um einen gleichen vorgegebenen Wert erhöhen können.

## Claims

1. Process for generating an output clock signal from a main clock signal (CKIN) having a predetermined main frequency (F0) and a secondary clock signal (SHC), in which a frequency synthesizer (SYF), which receives the secondary clock signal, is controlled by a two-state control logic signal (SC1), the synthesizer formulating and delivering selectively, in the guise of output clock signal, one or the other of first and second auxiliary clock signals (SHX1, SHX2), depending on whether the control signal is in its first and second states respectively, the first auxiliary signal (SHX1) having a first auxiliary frequency (F1) equal to the value of the main frequency plus a predetermined frequency gap greater than the frequency accuracy (ΔFQ) of the secondary clock signal, and the second auxiliary signal (SHX2) having a second auxiliary frequency (F2) equal to the value of the main frequency minus the said predetermined frequency gap, and one or the other of the two states of the logic signal (SC1) is determined as a function of the phase difference between, on the one hand, the auxiliary clock signal (CKOUT) delivered by the frequency synthesizer and, on the other hand, the main clock signal (CKIN) possibly altered, in such a way as to generate, at the output of the frequency synthesizer, an output clock signal (CKOUT) whose gap in frequency with respect to the said main frequency remains permanently below a predetermined threshold dependent on the said frequency gap and on the frequency accuracy of the generator of the secondary signal, even in the case of a temporary loss of the main signal.

2. Process according to Claim 1, **characterized in that** the logic signal (SC1) is given its first state when the auxiliary signal delivered by the synthesizer exhibits a phase lag with respect to the main signal (CKIN), and **in that** the logic signal is given its second state when the auxiliary signal delivered by the synthesizer has a phase lead with respect to the main signal.

3. Electronic device for generating an output clock signal, **characterized in that** it comprises a main input (EP) for receiving a main clock signal (CKIN) having a predetermined main frequency, a generator (GN) of a secondary clock signal (SHC), a frequency synthesizer (SYF) receiving the secondary clock signal as well as a two-state control logic signal (SC1) and formulating and delivering, in the guise of output clock signal (CKOUT), selectively one or the other of first and second auxiliary clock signals (SHX1, SHX2), depending on whether the control signal (SC1) is in its first and second states respectively, the first auxiliary signal (SHX1) having a first auxiliary frequency equal to the value of the main frequency plus a predetermined frequency gap greater than the frequency accuracy (ΔFQ) of the secondary clock signal, and the second auxiliary signal (SHX2) having a second auxiliary frequency equal to the value of the main frequency minus the said predetermined frequency gap, and control means (MCD) having a first control input (BC1) linked to the said main input (EP), a second control input (BC2) linked to the output of the frequency synthesizer and which are able to deliver the said logic signal and to give it one or the other of its two states as a function of the phase difference between the signals present respectively at the two control inputs, in such a way as to generate, at the output of the frequency synthesizer, an output clock signal (CKOUT) whose gap in frequency with respect to the said main frequency remains permanently below a predetermined threshold dependent on the said frequency gap and on the frequency accuracy of the generator of the secondary signal, even in the case of a temporary loss of the main signal.

4. Device according to Claim 3, **characterized in that** the control means (MCD) give the logic signal its first state when the auxiliary signal delivered by the synthesizer exhibits a phase lag with respect to the signal (CKIN) present at the first control input, and **in that** the control means give the logic signal its second state when the auxiliary signal delivered by the synthesizer has a phase lead with respect to the signal present at the first control input.

5. Device according to Claim 3 or 4, **characterized in that** the control means comprise a phase and frequency detector (PFD) whose two inputs are linked to the two control inputs and delivering on its two outputs (BS1, BS2) two pulses (PS1, PS2) whose respective durations depend on the phase difference between the signals present at the two inputs (BC1, BC2), two low-pass filters (LP1, LP2), connected respectively to the two outputs of the phase and frequency detector, and comparison means (CMP) whose two inputs are linked to the two outputs of the two filters, and whose output delivers the said logic signal (SC1).

6. Device according to Claim 5, **characterized in that** the comparison means comprise a comparator (CMP) preceded by two level-offsetting means (LS1, LS2) able to increase the level of each signal delivered by each filter by the same predetermined value.
